Europäisches Patentamt

European Patent Office

Office européen des brevets

(11) Publication number: **0 204 102**
**A2**

# EUROPEAN PATENT APPLICATION

(21) Application number: **86104732.2**

(22) Date of filing: **07.04.86**

(51) Int. Cl.⁴: **H01L 21/60 , H01L 23/48**

(30) Priority: **03.06.85 US 740664**

(43) Date of publication of application:
**10.12.86 Bulletin 86/50**

(84) Designated Contracting States:
**DE FR IT NL**

(71) Applicant: **MOTOROLA, INC.**
**1303 East Algonquin Road**
**Schaumburg, Illinois 60196(US)**

(72) Inventor: **Lin, Paul T.**
**9813 Manderville Circle**
**Austin Texas 78750(US)**

(74) Representative: **Ibbotson, Harold et al**
**Motorola Ltd Patent and Licensing**
**Operations - Europe Jays Close Viables**
**Industrial Estate**
**Basingstoke Hampshire RG22 4PD(GB)**

(54) **Direct connection of lead frame having flexible, tapered leads and mechanical die support.**

(57) Method and apparatus connecting a semiconductor die 24 with a direct lead frame 14 by mounting the semiconductor die 24 on a mechanical die support 22 and using the support 22 to align bonding pads 26 on the die 24 with flexible, tapered inner leads 30 of the lead frame 14. The direct lead frame 14 has flexible tapered leads 30 to directly bond a semiconductor die 24 with the lead 20 that will ultimately form the external package lead 36. The leads 20 derived from the lead frame stock are made more flexible in the direction in which they are to be moved for bonding to a semiconductor die 24 by making the leads 20 narrower in thickness as well as in width. This structural change may be accomplished by one or more chemical step-etchings or by machining.

*FIG. 1*

# DIRECT CONNECTION OF LEAD FRAME HAVING FLEXIBLE, TAPERED LEADS AND MECHANICAL DIE SUPPORT

## Technical Field

This invention relates generally to lead frames and, more particularly, to apparatus and methods for directly connecting a lead frame to a semiconductor device.

## Background Art

Various methods have been proposed for providing electrical connections between the bonding pads of an integrated microcircuit and the external package leads. Traditionally this connection has been achieved by establishing a very fine wire contact between the bonding pads of the semiconductor device and the narrow lead fingers of a lead frame, where the lead frame fingers would gradually widen and become substantial enough to form the external package leads. This wire bonding technique involves the thermocompression bonding of extremely fine wires to the points to be interconnected. However, this method is time-consuming and expensive, particularly when it is realized that for a 64-lead device, for example, 128 separate bonding steps are needed, each of which requires the careful positioning of the partially assembled device in the bonding apparatus.

Considerable attention has been devoted to trying to extend the internal portions of the package leads and tapering the lead ends in width to provide bonding tips which are small enough for attachment directly to the bonding pads of the semiconductor device. Previously this approach has not been successful, due primarily to the fundamental difference in structural specifications required for external package leads as compared with the specifications required of internal leads bonded to the ohmic contact areas of a microcircuit.

For example, the use of external package leads made of 10 mil thick Kovar has become a standard practice for many devices. However, efforts to bond 10 mil Kovar leads directly to the electrodes of an integrated circuit have proved disappointing. High-speed techniques for gold or aluminum wire bonding such as thermocompression and vibratory pressure welding do not readily produce a reliable bond when applied to metal leads as thick as 10 mils or when applied to metal leads which are less ductile than gold, aluminum or copper, for example. Even when acceptable bonds are initially formed using a 10 mil thick lead frame, the leads are very susceptible to inadvertent detachment from the die as a result of subsequent stresses introduced by normal handling and incidental flexing of the assembly.

It has also been proposed to replace bonding wires with individual rigid metal clips for interconnecting the bonding pads of the semiconductor circuit with the external leads. While this approach may be advantageous for some applications, it has not been found to reduce the cost of assembly substantially.

One proposed solution to the problem disclosed in U.S. Patent 4,028,722 to Helda is to simultaneously bond all leads of a first frame member to the corresponding bonding pads of a semiconductor integrated circuit chip. This first framemember is of relatively lightweight construction, suitable for vibratory pressure welding. The leads of this first frame member are then bonded to the leads of a second, relatively heavier frame member, whose heavier sheet metal stock is suitable for external package leads. The supportive framework of the first frame member is subsequently removed.

Other typical lead frame designs include those of U.S. Patent 4,137,546 to Frusco and U.S. Patent 4,280,132 to Hayakawa, et al. The former teaches long internal leads held structurally rigid by scored, detachable tabs. The latter patent involves a traditional wire bonded lead frame having improved blocking members to prevent mold spread.

As integrated circuit technology advanced, requiring more electronic devices on a smaller silicon chip, other possibilities for connecting to the semiconductor bonding pads were explored. One method which has gained wide acceptance, at least for relatively low lead-count semiconductor devices, is tape automatic bonding or TAB. This technique involves making flexible lead carrier tape having a photolithographically produced printed circuit pattern of conductive flexible foil thereon which is very accurate. In contrast to the lead frame thickness, the thicknes of the TAB foil leads is typically in the range of about 0.5 to 2.0 mil, often about 1.4 mil. This reduced size permits TAB foil leads to be used on smaller, more closely spaced bonding pads of the increased density integrated circuits. For an overview of tape automated bonding technology, see T.G. O'Neill, "The Status of Tape Automated Bonding", Semiconductor International, February, 1981, pp. 33-51.

A number of patents have issued on TAB technology. Not surprisingly, given the very small dimensions of the flexible foil TAB leads, a concern in many of these patents is how to keep the fragile leads from bending. For example, see U.S. Patent 4,312,926 to Burns which teaches the use of an interior tear strip which holds the leads in a planar orientation during handling and bonding, which is subsequently removed. U.S. Patent 4,330,790 also to Burns relates how a semiconductor device which has been gang bonded to a continuous tape contact finger pattern may be encapsulated via a metal package cup.

An improvement of the interior tear strip holding frame scheme mentioned in U.S. Patent 4,312,926 above is seen in U.S. Patent 4,380,042 to Angelucci. Alternate methods of protecting and holding the leads in place along their outside ends (as opposed to their interior ends) are evident in U.S. Patent 4,466,183 to Burns. However, in practice it has been discovered that in using the foil lead patterns to bond to the semiconductor product pads, the leads, being of uniform thickness, are much too thin to serve as external package leads to be plugged into a printed circuit board, for instance. Typically, this problem has been solved by wire bonding the exterior or outside foil pattern leads to the internal ends of the leads of a larger, thicker lead frame in which the exterior or outside leads are substantial enough to serve as external package leads. For example, see U.S. Patent 4,331,740 to Burns for a description of how these tape leads must be connected to a secondary lead frame. Thus, although the TAB foil leads solve the problem of connecting to smaller and more closely spaced integrated circuit bonding pads, due to the small flexible foil leads, they are not so versatile as to get away from the expensive, time-consuming task of wire bonding.

A few patents have been found which concern, to a very limited extent, the narrowing in the thickness dimension of leads to be connected to the bonding pads of an integrated circuit. U.S. Patent 4,331,740 to Burns teaches a TAB tape having a very small, narrowed portion designed to be severed after bonding of the leads. Similarly, tape leads which have been pinched in their thickness dimension to facilitate eventual breakage are disclosed in FIG. 5-C of U.S. Patent 4,234,666 to Gursky. In neither of these two cases does the lead thickness narrowing extend beyond the point at which breakage is desired.

U.S. Patent 4,411,719 to Lindberg in FIG. 5 discloses leads which have been varied in thickness in very specific spots creating holes or troughs, apparently to provide bonding bumps on the tape leads rather than on the integrated circuit bonding pads, and to facilitate registration of the bumped lead on the bonding pad through a miniature physical alignment. Another structure using bumped tape which gives the impression that part of the rest of the lead is narrowed, when in fact only a bump has been placed on the end of the lead finger is taught by U.S. Patent 4,312,926 to Burns.

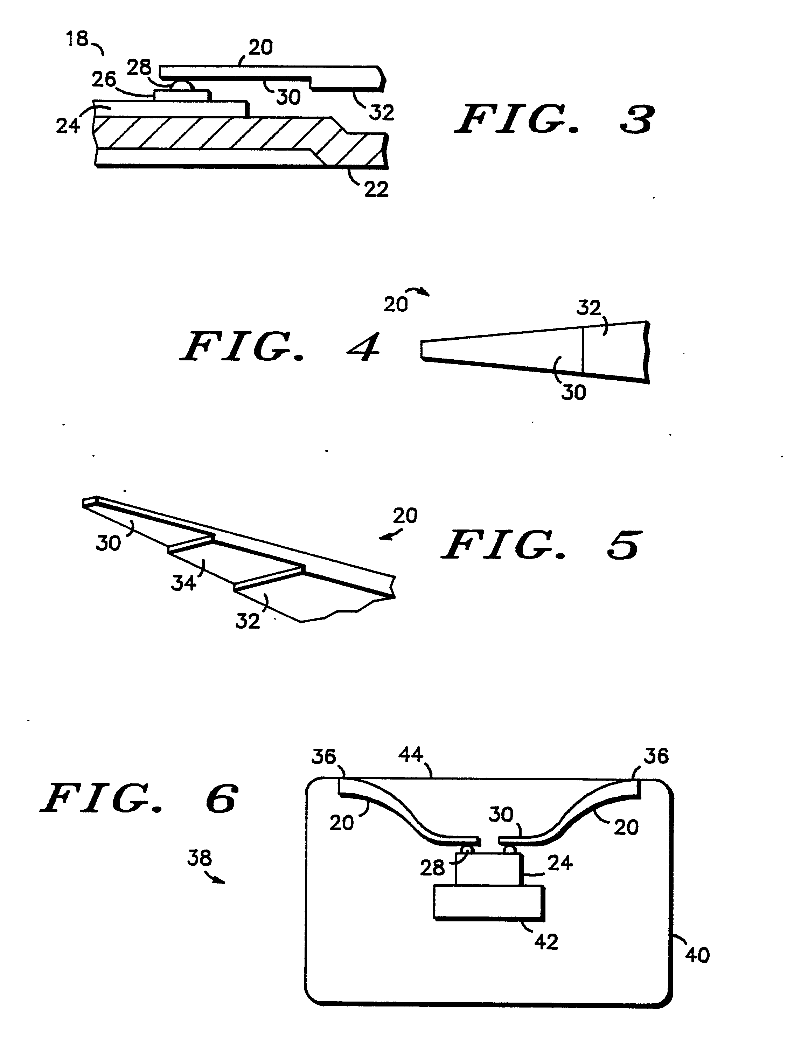

Another patent of interest is U.S. Patent 3,627,901 to Happ which discloses in FIGs. 3, 5 and 7 interior leads of a lead frame which have been reduced in thickness to provide an empty volume within the lead frame to accomodate the volume of an inverted semiconductor device.

Another problem in the packaging of integrated circuits concerns the careful handling of the very tiny chips or dice, particularly with respect to positioning them to correspond accurately to the lead frame to which they are going to be connected.

Brief Summary of the Invention

Accordingly, an object of the present invention is to completely avoid the necessity for employing wire bonding, with its multi-step, time and expense requirements, at any step in the packaging and lead connection process.

Another object of the present invention is to provide a technique for connecting leads to the small, closely spaced bonding pads of current semiconductor products.

A further object of the present invention is to provide a means for directly connecting the integrated circuit die bonding pads with the external package leads with one only contact.

Yet another object of the invention is to provide direct lead frame that requires a minimum of processing prior to bonding to the semiconductor die.

Still another object of the invention is to provide a method of interconnecting a lead frame and a semicondcutor die so that the semiconductor die bonding pad pattern may be precisely aligned with the pattern of inner lead ends of the lead frame by using a mechanical support for the die.

In carrying out the above and other objects of the present invention, there is provided, in one form, a method for connecting a semiconductor device or die to a direct lead frame using a mechanical die support. First, the semiconductor die is mounted on a mechanical die support. Next, the semiconductor die is positioned beneath a direct lead frame by manipulating the mechanical die support so that the pattern of bonding pads correspond to and are registered beneath a plurality of tapered flexible inner electrical lead tips. In these descriptions, "tapered" refers to a reduction or narrowing in thickness as well as in width. Finally, the tapered flexible inner electrical lead tips are gang bonded to the plurality of bonding pads on the semiconductor device. Semiconductor die/direct lead frame assemblies made by the method of this invention are also described.

Brief Description of the Drawings

FIG. 1 illustrates a top plan view of a semiconductor die/direct lead frame assembly constructed in accordance with this invention positioned over a semiconductor die mounted on a heat spreader support;

FIG. 2 illustrates a cross-sectional view of the lead frame connected to a die mounted on a heat spreader support taken on line 2-2 of FIG.1;

FIG. 3 illustrates a detailed cross-sectional view of how a finger shaped lead made according to this invention contacts a bump on a semiconductor die bonding pad;

FIG. 4 illustrates a bottom plan view of the finger-shaped lead of FIG. 3;

FIG. 5 illustrates a three-quarters view of the bottom of a finger-shaped lead constructed in accordance with an alternate embodiment of the present invention; and

FIG. 6 illustrates a block schematic plan view of a credit card bearing a semiconductor die connected to a lead frame constructed in accordance with the present invention.

Detailed Description of the Invention

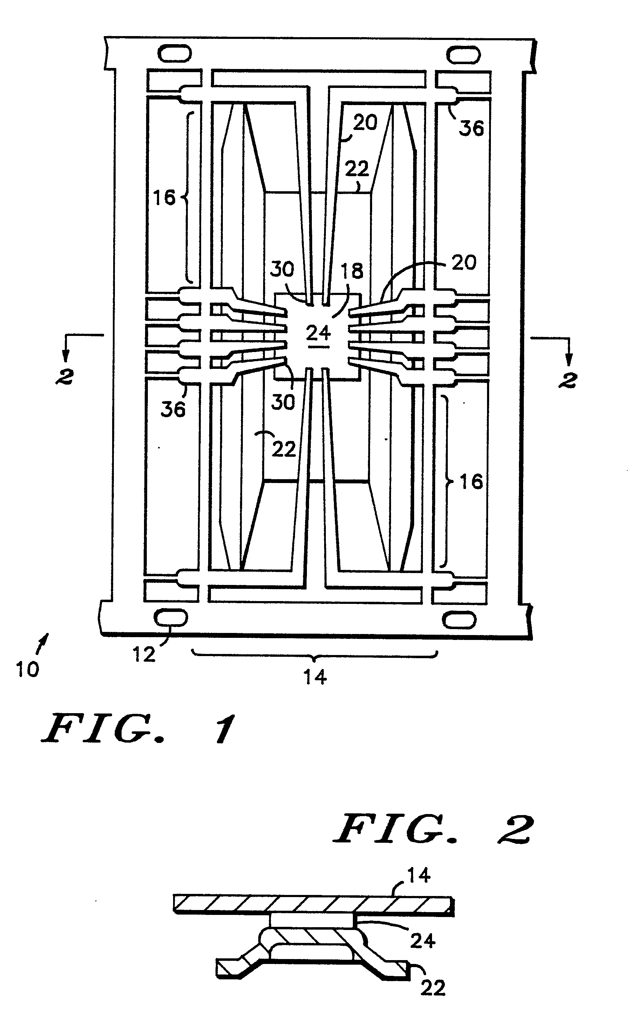

Shown in FIG. 1 is a segment of a continuous rigid lead frame strip 10 provided with a plurality of indexing sprockets 12, which is also provided with a plurality of sequentially arranged lead frames 14. A single direct lead frame 14 is illustrated in FIG. 1. Within each lead frame 14 is a detailed lead frame conductive pattern 16 which is a geometric arrangement of a plurality of finger-shaped leads 20 for making electrical contact with the semiconductor die 24 as well as for terminating in the eventual external package lead ends 36. The finger-shaped leads 20 run from an aperture 18 for receiving a semiconductor die 24 to the outer edges of the direct lead frame 14. Typically, the aperture 18 is positioned at or near the center of the lead frame conductive pattern 16. It will be appreciated by those skilled in the art that only a few finger-shaped leads 20 are illustrated in FIG. 1 for the sake of clarity. The number of leads 20 in a lead frame 14 could be one hundred or more. The initial method of fabrication of the leads 20 is immaterial to the invention. They may be chemically etched or mechanically stamped according to well-known processes.

The semiconductor die 24 is first mounted on a mechanical die support 22 before being bonded or connected to the leads 20. Using the mechanical die support 22 as the mount for the integrated circuit greatly facilitates handling and alignment of the tiny IC chip. In addition, the presence of the mechanical die support 22 protects the semiconductor die 24 and its lead connections to some extent. Otherwise, the semiconductor die 24 may be left dangling from the leads 20 without support.

Mechanical die support 22 may be a backside electrical contact of some sort, a mechanically bonded armature or a heat spreader device. FIGS. 1 and 2 actually show a heat spreader for mechanical die support 22. Of course, the other primary function of a heat spreader support 22 is to serve as a heat sink to dissipate heat generated by the integrated circuit during operation.

One of the primary features of the invention may be seen from FIG. 1, namely that only one lead is necessary to run from the semiconductor die 24 to the external lead ends 36. Thus, no wire bonding is necessary at any point from the circuit to the external package plugs, greatly reducing the number of processing steps, as well as reducing the time and expense spent on interconnecting each semiconductor product. The entire assembly of semiconductor die 24, heat spreader 22 and lead frame 14 may be termed a semiconductor die/direct lead frame assembly.

Shown in FIG. 2 is a cross-sectional view of the direct lead frame 14, semiconductor die 24 and heat spreader support 22 taken substantially on line 2-2 of FIG. 1. The support position of mechanical die support 22 is clearly seen in FIG. 2. It will be appreciated that the thicknesses of lead frame 14, semiconductor die 24 and support 22 are greatly exaggerated in FIG. 2 relative to their width for clarity.

Shown in FIG. 3 is a partial cross-sectional view oriented similarly to FIG. 2 but providing much more detail with respect to how lead 20 is connected to semiconductor die 24 mounted upon heat spreader or mechanical die support 22. Semiconductor die 24 is provided on its topmost layer with a plurality of terminals or bonding pads 26 which are electrically connected to the integrated circuit imbedded in the semiconductor die 24. The bonding pads 26 are, strictly speaking, various metallization layers built up over the imbedded integrated circuit terminals as is well-known in the art. It is customary in the production of the semiconductor product to also put "balls" or "bumps" 28 of material on the bonding pads 26 to facilitate interconnection with leads 20. In the instance where the TAB technique is employed, gold and copper bumps 28 are typically employed, preferably gold. The use of gold bumps makes the TAB process adapted for thermocompression bonding of the lead 20 to the bonding pad 24. Occasionally, the lead tip surfaces are "bumped" instead of the bonding pads. While thermocompression bonding has certain process advantages, such as a lower temperature, over solder reflowing, it also has the disadvantage of requiring soft, ductile (and therefore precious and expensive) metals such as gold. In trying to reduce the costs of semiconductor products, the use of expensive metals should be minimized. Additionally, thermocompression bonding runs the risk of crushing the bonding pad and gold bump into the silicon base substrate forming an active device. Thus, it is preferable in many instances to avoid thermocompression methods and use solder reflow techniques to form the connection. No possibly harmful compressive force is used and the surface tension of the molten solder precisely aligns the end of lead 20 over bonding pad 26. Thus, solder reflowing techniques are preferred herein and are made possible by using lead frames instead of TAB foils which are made out of more expensive metals. Lead frames may be made from alloy 42, copper alloy, either with or without tin plating, which are relatively less expensive metals. Thermocompression and solder reflow bonding techniques are well-known processes in the art and will not be discussed in further detail herein. It is also well-known to plate the underside of leads 20 with metals such as copper, gold or tin to facilitate the bonding. Additionally, techniques to passivate and/or protect the actual bonding pad 26 (typically aluminum) with diffusion barrier metal or adhesion metal layers of various types are well-known to those skilled in the art.

FIG. 3 illustrates the variable thickness of lead 20, an important feature of the invention. As noted previously, lead frame metal is ordinarily rigid and thick as required for suitable external lead ends 36. Even the shrinking or narrowing of the width of leads 20 as they approach aperture 18 from the edges of the direct lead frame 14 as seen in FIG. 1 is not enough to make the leads flexible or ductile enough for direct attachment to the bonding pads 26 by either solder reflowing or thermocompression techniques. However, it has been surprisingly discovered that if the thickness of the leads 20 is reduced, that cantilevered flexible inner electrical lead tips 30 result which are adapted for the direct connection described above. The relatively rigid primary lead portion 32 is unreduced from its original thickness in any way. By way of contrast, cantilevered and tapered flexible inner electrical lead tip 30 has had its thickness reduced appreciably. Preferably, the thickness of cantilevered flexible inner electrical lead tip 30 is at least 50% of the thickness of rigid primary lead portion 32. It will be understood that the terms "rigid" and "flexible" are used in a relative sense. "Rigid" primary lead portion 32 may be perceived as very thin and flexible to human senses, but would in fact be too rigid to be bonded properly. If the lead is "flexible" then it is of sufficient vertical mobility to bond properly.

Shown in both FIGS. 3 and 4 is a segment of a finger-shaped lead 20, from the side in FIG. 3 and from the bottom in FIG. 4. The cantilevered flexible inner electrical lead tip 30 has been step-etched into the bottom of lead 20. The method of fabrication of lead tip 30 is immaterial; it may be created by machine tooling, chemical mask etching or other means well-known in the art. It should be noted from both FIGS. 1 and 3 that inner electrical lead tip 30 is cantilevered out over or into aperture 18 so as to properly contact bump 28 and bonding pad 26.

Shown in FIG. 5 is a foreshortened three-quarters view of an alternate embodiment of finger-shaped lead 20 of the present invention. It should be noted that the lead 20 has sections of three different thicknesses to provide an ever-narrowing lead as it points toward aperture 18 with ever-increasing flexibility. The thickest section is the unmodified portion of lead frame 14 lead 20 designated as rigid primary lead portion 32. After appropriate processing, such as chemical mask etching, intermediate lead portion 34 of intermediate thickness may be formed. Finally, lead 20 terminates in subsequently step-etched cantilevered flexible inner electrical lead tip 30 as described previously. Intermediate lead portion 34 may be desirable as the lead 20 also narrows in width dimension so that too sharp a change in thickness and relative flexibility with accompanying its risk of breakage would not occur. The number of steps to reduce thickness and provide flexibility is arbitrary and depends on the situation. The length of lead 20 that needs to be tapered and thinned is also somewhat arbitrary as long as increased flexibility is attained.

It is readily apparent that the thickness of lead 20 could be reduced by other techniques to give side profiles other than the ones illustrated herein. For example, instead of a stepped reduction in thickness, this dimension might be smoothly or gradually reduced resulting in a thin, wedge-shaped profile. As chemical mask etching is a well-practiced art in the semiconductor industry, it is expected that step-etching leads 20 would be easier initially than a gradual reduction in thickness which may have to be done by machine tooling. After assembly, the entire connected semiconductor device would be encapsulated, if desired, as is well-known in the art through plastic injection molding. The external lead ends would be shaped or bent if necessary, to form the desired dual in-line package (DIP) or plastic leaded chip carrier - (PLCC) configuration in accordance with design specifications.

Shown in FIG. 6 is a schematic plan view of a "smart" credit card 38 employing leads 20 in accordance with the present invention. In this embodiment, the two leads 20 would make up the entire representation of direct lead frame 14 and lead frame conductive pattern 16. Aperture 18 may be defined as the space between and beneath cantilevered flexible inner electrical lead tips 30. In general terms, a semiconductor die 24 is mounted on a semiconductor die support 42. Semiconductor die support 42 performs the same support function of and is analogous to mechanical die support 22. Die support 42 may also be adapted to serve as a heat sink mechanism, if necessary. The die support 42 bearing semiconductor die 24 is in turn mounted within credit card body 40. As described above, the semiconductor die 24 is provided with terminal bumps 28 which are ultimately bonded to flexible inner electrical lead tips 30 of finger-shaped leads 20. Connection with an outside device is provided by external lead ends 36 which are relatively thicker than thin flexible inner lead tips 30. Finally, the semiconductor die 24 and leads 20 would be encapsulated using materials 44 and techniques well-known in the art.

It may be seen from FIG. 6 that leads 20 may be of curved rather than straight configuration, and may also taper gradually in thickness along their length from relatively thick external lead ends 36 to very thin inner lead tips 30, in contrast to the stepped profile seen in FIG. 5. The other advantages of the invention may also be seen in the embodiment of FIG. 6. For instance, only one connection per lead is required in contrast to the previous technique using wire bonds and at least one, if not more, outer lead bond before the external package lead is reached.

In practice, the method of this invention begins by mounting semiconductor die 24 on mechanical die support 22, or in the case of "smart" credit card 38 on semiconductor die support 42. The mechanical die support 22 or die support 42 is then manipulated until the pattern of the plurality of bonding pads 26 on the surface of semiconductor die 24 are aligned with or registered with the pattern 16 of the plurality of tapered flexible inner lead tips 30. Finally all of the inner lead tips 30 are simultaneously or "gang" bonded to the semiconductor die 24 bonding pads 26 in proper registration. The tapered nature of the inner lead tips 30, particularly in thickness, permits their flexible bending to the pads 26 during bonding.

It will be appreciated that the method of this invention could be carried out as a continuous sequence. In fact, the individual lead frames 14 would not necessarily have to be separated from continous rigid lead frame strip 10. A group of interconnected lead frames 14 and semiconductor die 24 and protective, heat spreader supports 22 could be handled together, or even shipped together on a portion of continuous rigid lead frame strip 10.

## Claims

1. A method for connecting a semiconductor die 24 to a direct lead frame 14 comprising:

mounting a semiconductor die 24 on a heat spreader mechanical die support 22, wherein the semiconductor die 24 has a plurality of bonding pads 26 on the exposed surface thereof;

positioning the semiconductor die 24 beneath the direct lead frame 14 by manipulating the heat spreader mechanical die support 22 such that the plurality of bonding pads 26 correspond to and are registered beneath a plurality of tapered flexible inner electrical lead tips 30 of the lead frame 14; and

gang bonding the plurality of tapered flexible inner electrical lead tips 30 to the plurality of bonding pads 26 in proper correspondence.

2. A method for connecting a semiconductor die 24 to a direct lead frame 14 comprising:

mounting a semiconductor die 24 on a heat spreader mechanical die support 22, wherein the semiconductor die 24 has a plurality of bonding pads 26 on the exposed surface thereof;

positioning the semiconductor die 24 beneath the direct lead frame 14 where the direct lead frame 14 comprises:

a lead frame conductive pattern 16,

a semiconductor die receiving aperture 18 within said lead frame conductive pattern 16, and

a plurality of elongated finger-shaped leads 20 converging towards said aperture 18, said finger-shaped leads 20 comprising:

external lead ends 36;

rigid primary lead portions 32; and

tapered flexible inner electrical lead tips 30 having a reduced width and thickness from the rigid primary lead portions 32 in a common plane with said aperture 18;

and where the positioning is accomplished by manipulating the heat spreader mechanical die support 22 such that the plurality of bonding pads 26 correspond to; and are registered beneath the plurality of tapered flexible inner electrical lead tips 30 of the lead frame 14; and

gang bonding the plurality of tapered flexible inner electrical lead tips 30 to the plurality of bonding pads 26, in proper correspondence.

3. A method for connecting a semiconductor die 24 to a direct lead frame 14 comprising:

mounting a semiconductor die 24 on a heat spreader mechanical die support 22, wherein the semiconductor die 24 has a plurality of bonding pads 26 on the exposed surface thereof;

positioning the semiconductor die 24 beneath the direct lead frame 14 where the direct lead frame comprises:

a lead frame conductive pattern 16,

a semiconductor die receiving aperture 18 within said lead frame conductive pattern 16, and

a plurality of elongated finger-shaped leads 20 converging towards said aperture 18, said finger-shaped leads 20 comprising:

external lead ends 36;

rigid primary lead portions 32; and

tapered flexible inner electrical lead tips 30 having a reduced width and thickness of at least 50% in each direction from the rigid primary lead portions 32, in a common plane with said aperture 18; and where the positioning is accomplished by manipulating the heat spreader mechanical die support 22 such that the plurality of bonding pads 26 correspond to; and are registered beneath the plurality of tapered flexible inner electrical lead tips 30 of the lead frame 14; and

gang bonding the plurality of tapered flexible inner electrical lead tips 30 to the plurality of bonding pads 26 in proper correspondence.

4. A method for connecting a plurality of semiconductor die 24 to a continuous lead frame strip 10 comprising:

sequentially mounting the plurality of semiconductor die 24 one each on a plurality of heat spreader mechanical die supports 22, wherein the semiconductor die 24 have a plurality of bonding pads 26 on the exposed surfaces thereof;

sequentially positioning the plurality of semiconductor die 24 one each beneath a plurality of rigid lead frame conductive patterns 16 linearly attached on opposite sides to one another to form the lead frame strip 10, for positioning and registering, by manipulating the heat spreader mechanical die support 22, the plurality of bonding pads 26 on each semiconductor die 24 to correspond with a plurality of tapered flexible inner electrical lead tips 30 of the individual lead frame conductive pattern 16; and sequentially gang bonding the plurality of tapered flexible inner electrical lead tips 30 to the plurality of bonding pads 26 in proper correspondence.

5. A semiconductor die/direct lead frame assembly made by the process comprising:

mounting a semiconductor die 24 on a heat spreader mechanical die support 22, wherein the semiconductor die has a plurality of bonding pads 26 on the exposed surface thereof;

positioning the semiconductor die 24 beneath the direct lead frame 14 by manipulating the heat spreader mechanical die support 22 such that the plurality of bonding pads 26 correspond to and are registered beneath a plurality of tapered flexible inner electrical lead tips 30 of the lead frame 14; and gang bonding the plurality of tapered flexible inner electrical lead tips 30 to the plurality of bonding pads 26 in proper correspondence.

6. The semiconductor die/direct lead frame assembly of claim 5 in which the direct lead frame 14 comprises:

a lead frame conductive pattern 16,

a semiconductor die receiving aperture 18 within said lead frame conductive pattern 16, and

a plurality of elongated finger-shaped leads 20 converging towards said aperture 18, each said finger-shaped lead 20 comprising:

external lead ends 36;

rigid primary lead portions 32; and

tapered flexible inner electrical lead tips 30 having a reduced width and thickness from the rigid primary lead portions 32 in a common plane with said aperture 18 for connecting to the plurality of bonding pads 26 on a semiconductor die 24.

7. The semiconductor die/direct lead frame assembly of claim 5 in which the width and thickness of said finger-shaped leads 20 are reduced in one or more steps.

8. The semiconductor die/direct lead frame assembly of claim 5 in which the width and thickness of said finger-shaped leads 20 are reduced gradually.

9. The semiconductor die/direct lead frame assembly of claim 5 in which the thickness of the cantilevered flexible inner electrical lead tips 30 is 50% or less of the thickness of the rigid primary lead portions 32.

10. A semiconductor die/direct lead frame assembly made by the process comprising:

mounting a semiconductor die 24 on a heat spreader support 22, wherein the semiconductor die 24 has a plurality of bonding pads 26 on the exposed surface thereof;

positioning the semiconductor die 24 beneath the direct lead frame 14, wherein the lead frame 14 comprises:

a lead frame conductive pattern 16;

a semiconductor die receiving aperture 18 within said lead frame conductive pattern 16; and

a plurality of elongated finger-shaped leads 20 converging towards said aperture 18, said finger-shaped leads 20 comprising:

external lead ends 36;

rigid primary lead portions 32; and

tapered flexible inner electrical lead tips 30 having reduced width and thickness from the rigid primary lead portions 32 in a common plane with said aperture 18,

the positioning done by manipulating the heat spreader support 22 such that the plurality of bonding pads 26 correspond to and are registered beneath the plurality of tapered flexible inner electrical lead tips 30 of the lead frame 14; and

gang bonding the plurality of tapered flexible inner electrical lead tips 30 to the plurality of bonding pads 26 in proper correspondence.

FIG. 1

FIG. 2

*FIG. 3*

*FIG. 4*

*FIG. 5*

*FIG. 6*